# EUROPÄISCHE PATENTSCHRIFT

(11) **EP 0 923 279 B1**
(45) Veröffentlichungstag und Bekanntmachung des Hinweises auf die Patenterteilung: **02.04.2003**
(21) Anmeldenummer: 98116796.8
(22) Anmeldetag: 05.09.1998
(51) Int. Cl.: H05K 7/14

(54) **Kartensicherung zum Sichern einer Leiterkarte**
Circuit board retainer
Dispositif de retenue d'une carte électronique

(30) Priorität: 11.12.1997 DE 19755018
(43) Veröffentlichungstag der Anmeldung: 16.06.1999
(73) Patentinhaber: Schroff GmbH, D-75334 Straubenhardt (DE)
(72) Erfinder: Günther, Hans-Ulrich, 76327 Pfinztal (DE); Haag, Volker, 75323 Bad Wildbad (DE); Mazura, Paul, 76302 Karlsbad (DE); Pfeifer, Klaus, 76199 Karlsruhe (DE); Thalau, Klaus-Michael, 76316 Malsch (DE); Weiss, Udo, 75334 Straubenhardt (DE); Joist, Michael, 76571 Gaggenau (DE)
(74) Vertreter: Durm, Klaus, Dr.-Ing.

(56) Entgegenhaltungen:
- EP-A- 0 097 228
- EP-A- 0 690 667
- US-A- 5 302 133

## Beschreibung

Die Erfindung betrifft eine Kartensicherung zum Sichern einer Leiterkarte in einer Führungsschiene eines Baugruppenträgers, mit einem Halteelement, das bei in die Führungsschiene eingeschobener Leiterkarte vor der Vorderkante derselben liegt und zum Herausziehen der Leiterkarte gegen eine elastische Rückstellkraft wegschwenkbar ist. Eine solche Kartensicherung ist aus der EP-A-0 690 667 bekannt.

Leiterkarten mit elektrischen oder elektronischen Bauelementen, die in Baugruppenträgern oder sonstigen Gehäusen der Einschubtechnik eingebaut sind, werden üblicherweise an ihren Längskanten in Führungsschienen geführt, was ermöglicht, daß sie einfach in den Baugruppenträger oder das Gehäuse eingeschoben und bei Bedarf wieder herausgezogen werden können.

An ihrer Hinterkante weisen die Leiterkarten normalerweise Übergabesteckverbinder auf, welche die elektrische Verbindung mit dem Baugruppenträger bzw. dem Gehäuse herstellen. Durch die Klemmwirkung der Übergabesteckverbinder, vor allem bei hochpoligen Ausführungen, werden die Leiterkarten zwar bis zu einem gewissen Grad in ihrer Einbaulage gehalten; jedoch insbesondere bei Leiterkarten, die nicht mit einem Frontplattenstück versehen sind und gegebenenfalls - je nach Anwendungsgebiet - Vibrationen oder unregelmäßigen Querbeschleunigungen ausgesetzt sind, sind zusätzliche Sicherungsmaßnahmen erforderlich, um die Leiterkarten in ihrer Einbaulage zu halten. Hierzu dienen separate Kartensicherungen.

Eine Kartensicherung der eingangs genannten Art ist beispielsweise aus der Veröffentlichung Hoffman/Schroff: "Katalog für die Elektronik 96/97", Seiten 37.46 und 37.47, bekannt: Die dort dargestellte Kartensicherung umfaßt als Halteelement einen elastisch verformbaren Sicherungsbügel, der wahlweise von Hand (z.B. mit dem Daumen) oder mit einem Ein- und Aushebegriff weggeschwenkt werden muß, um die Leiterkarte herausziehen zu können. Der Sicherungsbügel ist hierbei Teil eines vor der Führungsschiene im Bereich einer vorderen Modulschiene eines Baugruppenträgers montierten Einbauteils.

Der Nachteil der bekannten Kartensicherungen macht sich beim Einschieben einer Leiterkarte in ihre Führungsschienen bemerkbar: Da sich der Sicherungsbügel einer solchen Kartensicherung aufgrund der auf ihn wirkenden elastischen Rückstellkraft wieder in seine Ruheposition, also der verriegelten Stellung, zurückbewegt, sobald die Leiterkarte ganz herausgezogen ist, behindert er das Einschieben der Leiterkarte erheblich: Die Leiterkarte muß dann nicht nur in ihre beiden Führungsschienen eingespurt, sondern es muß zusätzlich der Sicherungsbügel der Kartensicherung gegen die elastische Rückstellkraft weggeschwenkt werden, um ein Einschieben der Leiterkarte überhaupt zu ermöglichen. Besonders umständlich wird dieser Vorgang, wenn an beiden Führungsschienen zur Aufnahme der Leiterkarte Kartensicherungen montiert sind.

Ausgehend von diesem Stand der Technik liegt der Erfindung die Aufgabe zugrunde, eine Kartensicherung der eingangs genannten Art so zu verbessern, daß sie nur dann aktiviert ist, wenn eine Leiterkarte in den zugehörigen Baugruppenträger bzw. das zugehörige Gehäuse eingeschoben ist; die Kartensicherung soll also das Einschieben, insbesondere das Einspuren einer Leiterkarte in die zugehörigen Führungsschienen, nicht behindern.

Diese Aufgabe ist durch eine Kartensicherung mit den Merkmalen des Patentanspruchs 1 gelöst.

Vorteilhafte Ausgestaltungen und Weiterbildungen der Erfindung ergeben sich aus den Ansprüchen 2 bis 12.

Eine erfindungsgemäße Kartensicherung zum Sichern einer Leiterkarte in einer Führungsschiene eines Baugruppenträgers umfaßt also nicht nur ein Halteelement, das bei in die Führungsschiene eingeschobener Leiterkarte vor der Vorderkante derselben liegt und zum Herausziehen der Leiterkarte gegen eine elastische Rückstellkraft wegschwenkbar ist, sondern auch ein Aktivierungselement, das mit dem Halteelement elastisch gekoppelt ist und auf dieses bei eingeschobener Leiterkarte die elastische Rückstellkraft ausübt, während es an einer Längskante der eingeschobenen Leiterkarte anliegt. Bei ausgezogener Leiterkarte ist das Aktivierungselement frei beweglich, wobei dann die elastische Rückstellkraft auf das Halteelement entfällt.

Die sichernde Eigenschaft der erfindungsgemäßen Kartensicherung ist gegenüber dem Stand der Technik unverändert, wobei jedoch die oben beschriebenen Nachteile der bekannten Kartensicherungen beseitigt sind: Die erfindungsgemäße Kartensicherung schaltet sich über ihr Aktivierungselement selbsttätig ein, sobald eine Leiterkarte in die entsprechende Führungsschiene eingeschoben wird; wenn sich hingegen keine Leiterkarte in der zugehörigen Führungsschiene befindet, ist die erfindungsgemäße Kartensicherung inaktiv. Da das Aktivierungselement im letzteren Fall keine elastische Rückstellkraft auf das Halteelement ausübt, bleibt dieses in der geöffneten Stellung; ein Einschieben einer Leiterkarte ist problemlos und ohne Behinderung durch das Halteelement möglich.

Die Erfindung stellt also eine Kartensicherung mit alternierend stabilen Endlagen zur Verfügung, nämlich einer offenen Position des Halteelements und einer verriegelten Position. Die jeweils stabile Endlage der Kartensicherung wird durch das Einschieben oder das Ausziehen einer Leiterkarte jeweils selbsttätig hergestellt.

Eine bevorzugte Ausgestaltung der Erfindung besteht darin, daß das Halteelement und das Aktivierungselement einen gemeinsamen Drehpunkt aufweisen. Hierbei ist es besonders vorteilhaft, wenn das Halteelement und das Aktivierungselement eine elastisch verformbare Wippe bilden: Der hintere Teil der Wippe steht bei geöffneter Kartensicherung über die Einschubebene der Führungsschiene über und wird durch eine Leiterkarte, die in die Führungsschiene eingeschoben wird, heruntergedrückt. Hierdurch wird wegen der elastischen Verformbarkeit der Wippe eine Kraft auf den vorderen Teil der Wippe - das Halteelement - erzeugt, wodurch dieses nach dem Passieren der vorderen Kante der Leiterkarte nach oben schnappt. Nach dieser bevorzugten konstruktiven Ausgestaltung der Erfindung sind Halteelement und Aktivierungselement also einteilig ausgebildet, wobei zusätzliche Einbauteile, wie zum Beispiel Federn, für eine elastische Kopplung zwischen diesen Teilen entfallen. Die Montage der Wippe an bzw. vor der Führungsschiene erfolgt zweckmäßigerweise mittels eines Lagerelements, welches am Einbauort befestigt wird und in welchem die Wippe an ihrem Drehpunkt gelagert ist.

Zweckmäßig ist ein Ein- und Aushebegriff für die Leiterkarte, mittels welchem das Halteelement unter Ausnutzung der Hebelgesetze von der Vorderkante der Leiterkarte wegschwenkbar ist, um ein Ausziehen der Leiterkarte zu ermöglichen. Wenn das Halteelement und das Aktivierungselement der Erfindung als Wippe ausgebildet sind, die in einem Lagerelement gelagert ist, ist es vorteilhaft, wenn das Lagerelement eine erste und vorzugsweise auch eine zweite Abdrückschulter für den Ein- und Aushebegriff aufweist, wobei sich der Ein- und Aushebegriff an der ersten Abdrückschulter abstützt, um das Ausziehen der Leiterkarte zu ermöglichen, wohingegen er sich an der zweiten Abdrückschulter abstützt, um das Einschieben der Leiterkarte zu unterstützen.

Das Halteelement kann ein Sicherungsbügel sein, der konstruktiv besonders einfach zu realisieren ist. Ebenso kann auch das Aktivierungselement als Bügel ausgebildet sein, wobei dieser zweckmäßigerweise eine Auflaufschräge für die Leiterkarte aufweist.

Wenn das als Bügel ausgebildete Aktivierungselement Teil eines am Halteelement angeformten Federrahmens ist, ist die erfindungsgemäße Kartensicherung besonders vorteilhaft zu realisieren: Das Halteelement kann dann die für die Sicherungswirkung notwendige Eigenstabilität aufweisen, wobei das als Bügel ausgebildete Aktivierungselement aufgrund der elastischen Verformbarkeit des Federrahmens elastisch mit dem Halteelement gekoppelt ist. Die so ausgebildete Kartensicherung kann gleichwohl einteilig hergestellt werden, beispielsweise als Kunststoff-Spritzgußteil. Ebenso ist es nach dieser bevorzugten Ausführung der Erfindung möglich, das Aktivierungselement nicht direkt am Drehpunkt, sondern am Halteelement zu befestigen und somit indirekt an den Drehpunkt zu koppeln, wodurch der Hebelarm für das als Bügel ausgebildete Aktivierungselement vorteilhaft verlängert wird.

Bevorzugt nimmt das Halteelement bei ausgezogener Leiterkarte eine stabile Endlage unterhalb der Einschubebene der Führungsschiene ein, so daß jegliche Behinderung beim Einschieben einer Leiterkarte ausgeschlossen ist.

Ein Ausführungsbeispiel der Erfindung wird im folgenden anhand der Zeichnungen näher erläutert. Es zeigen:
- Figur 1: einen perspektivischen Ausschnitt aus einem Baugruppenträger mit vier erfindungsgemäßen Kartensicherungen;
- Figur 2: eine schematische Schnittdarstellung einer Kartensicherung bei eingeschobener Leiterkarte;
- Figur 3: eine schematische Schnittdarstellung einer zum Ausziehen der Leiterkarte geöffneten Kartensicherung;
- Figur 4: eine schematische Schnittdarstellung einer Kartensicherung beim Ausziehen einer Leiterkarte;
- Figur 5: eine schematische Schnittdarstellung einer Kartensicherung vor dem Einschieben einer Leiterkarte;
- Figur 6: eine schematische Schnittdarstellung einer Kartensicherung beim Einschieben einer Leiterkarte.

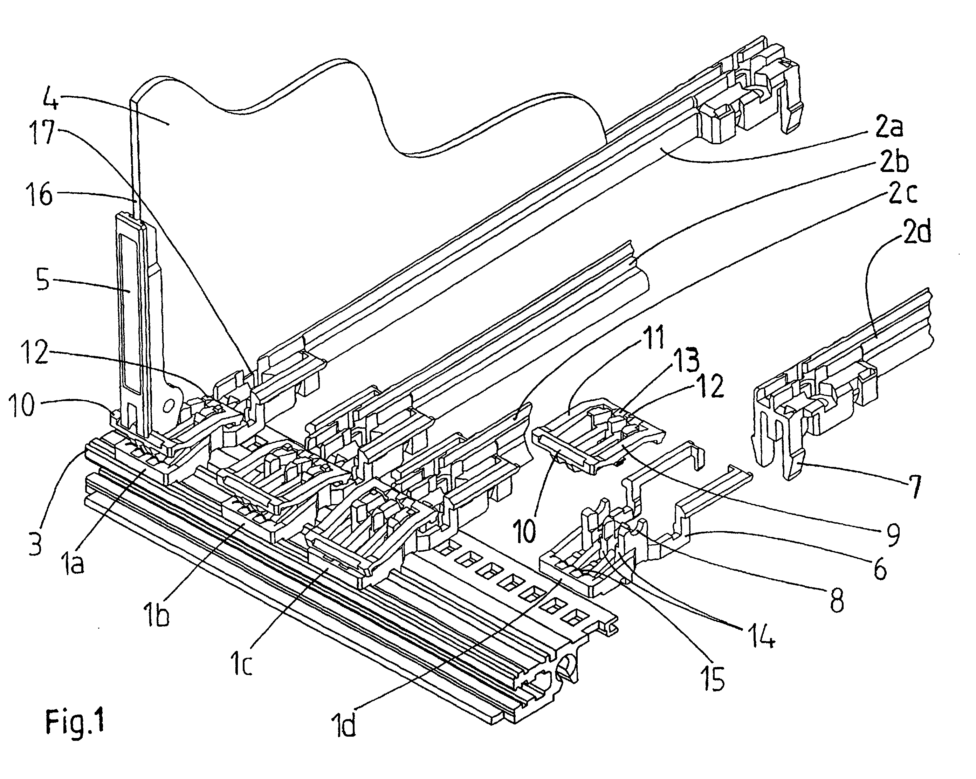

Figur 1 zeigt in perspektivischer Darstellung vier erfindungsgemäße Kartensicherungen 1a, 1b, 1c und 1d, die vor zugehörigen Führungsschienen 2a, 2b, 2c und 2d auf einer Modulschiene 3 eines (nicht dargestellten) Baugruppenträgers befestigt bzw. befestigbar sind.

Die Kartensicherung 1a ist in ihrer sichernden Stellung gezeigt: In der Führungsschiene 2a sitzt eine Leiterkarte 4 mit einem Ein- und Aushebegriff 5 in vollständig eingeschobenem Zustand.

Neben der Kartensicherung 1a ist die Kartensicherung 1b angeordnet, bei der zur Verdeutlichung die Leiterkarte 4 mit ihrem Ein- und Aushebegriff 5 nicht dargestellt ist. Daher ist die Kartensicherung 1b in der identischen Stellung wie die Kartensicherung 1a, also in der sichernden Stellung bei eingeschobener Leiterkarte 4 gezeigt.

Die Kartensicherung 1c zeigt deren Ruhezustand ohne eine in die Führungsschiene 2c eingeschobene Leiterkarte: Diese Kartensicherung 1c muß erst noch durch eine in die Führungsschiene 2c einzuschiebende Leiterkarte 4 aktiviert werden.

Die vierte Darstellung, die Kartensicherung 1d, soll deren Aufbau verdeutlichen; es handelt sich um eine explosionsartige Darstellung der Kartensicherung 1d und deren zugehörigen Führungsschiene 2d.

Die in Figur 1 dargestellten Kartensicherungen 1 umfassen jeweils ein Lagerelement 6, das zusammen mit der zugehörigen Führungsschiene 2 mittels deren Schnapphaken 7 an der Modulschiene 3 befestigt werden kann. Das Lagerelement 6 weist zwei Lagertragschalen 8 zur Aufnahme einer Wippe 9 auf, welche aus einem als Sicherungsbügel ausgebildeten Halteelement 10 und einem an diesem angeformten Federrahmen 11 mit einem bügelförmigen Aktivierungselement 12 besteht. Das Aktivierungselement 12 weist eine Auflaufschräge 13 für die Leiterkarte 4 auf, um deren Einschieben in die Führungsschiene 2 zu erleichtern. Das Lagerelement 6 besitzt außerdem erste Abdrückschultern 14, gegen die sich der Ein- und Aushebegriff 5 zum Ausziehen der Leiterkarte 4 abstützen kann. Gegenüberliegend befinden sich zweite Abdrückschultern 15, gegen welche sich der Ein- und Aushebegriff 5 beim Einschieben der Leiterkarte 4 abstützt.

Figur 1 verdeutlicht die Funktionsweise der erfindungsgemäßen Kartensicherung 1: Das Halteelement 10 der Kartensicherung 1a steht aufgrund der elastischen Verformbarkeit des Federrahmens 11 der Wippe 9 federbelastet vor der Vorderkante 16 der Leiterkarte 4 und sichert diese so vor dem Herausfallen. Um das Halteelement 10 mittels des Ein- und Aushebegriffs 5 zum Ausziehen der Leiterkarte 4 wegschwenken zu können, muß eine elastische Rückstellkraft überwunden werden, da das Aktivierungselement 12 durch die Längskante 17 der Leiterkarte 4 an einer Aufwärtsbewegung gehindert ist.

Sobald aber die Längskante 17 der Leiterkarte 4 nicht mehr an dem Aktivierungselement 12 anliegt, ist dieses um den in der Lagertragschale 8 liegenden Drehpunkt frei beweglich und die Wippe 9 kann die bei der Kartensicherung 1c gezeigte stabile Endposition einnehmen. Durch geeignete Wahl der Materialien und der Dimensionen der Wippe 9 und des Lagerelements 6 kann erreicht werden, daß die Wippe 9 bei ausgezogener Leiterkarte 4 immer die Position der Kartensicherung 1c einnimmt, um ein Einschieben der Leiterkarte 4 nicht zu behindern.

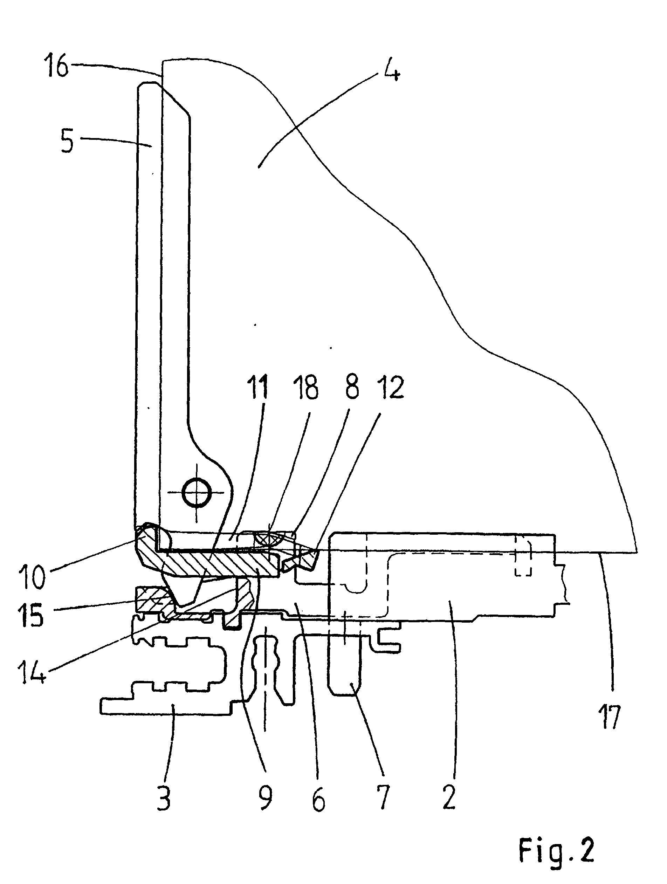

In den Figuren 2, 3, 4, 5 und 6 ist jeweils eine Leiterkarte 4 mit Ein- und Aushebegriff 5 dargestellt, die in die Führungsschiene 2 eingeschoben oder aus dieser herausgezogen wird. Die Führungsschiene 2 sitzt jeweils mit dem Schnapphaken 7 in der Modulschiene 3 und fixiert dabei das Lagerelement 6, in dessen Lagertragschale 8 ein Lagerinnenteil 18 der Wippe 9 sitzt.

Figur 2 zeigt die Kartensicherung 1 bei vollständig eingeschobener Leiterkarte 4; der Ein- und Aushebegriff 5 befindet sich in seiner Endposition, wobei er sich gegen die zweite Abdrückschulter 15 des Lagerelements 6 abstützt. Das Aktivierungselement 12 liegt unter leichter Vorspannung an der Längskante 17 der Leiterkarte 4 an. Da das Aktivierungselement 12 über den Federrahmen 11 elastisch mit dem Halteelement 10 gekoppelt ist, sitzt dieses ebenfalls unter leichter Vorspannung in sichernder Stellung vor der Vorderkante 16 der Leiterkarte 4.

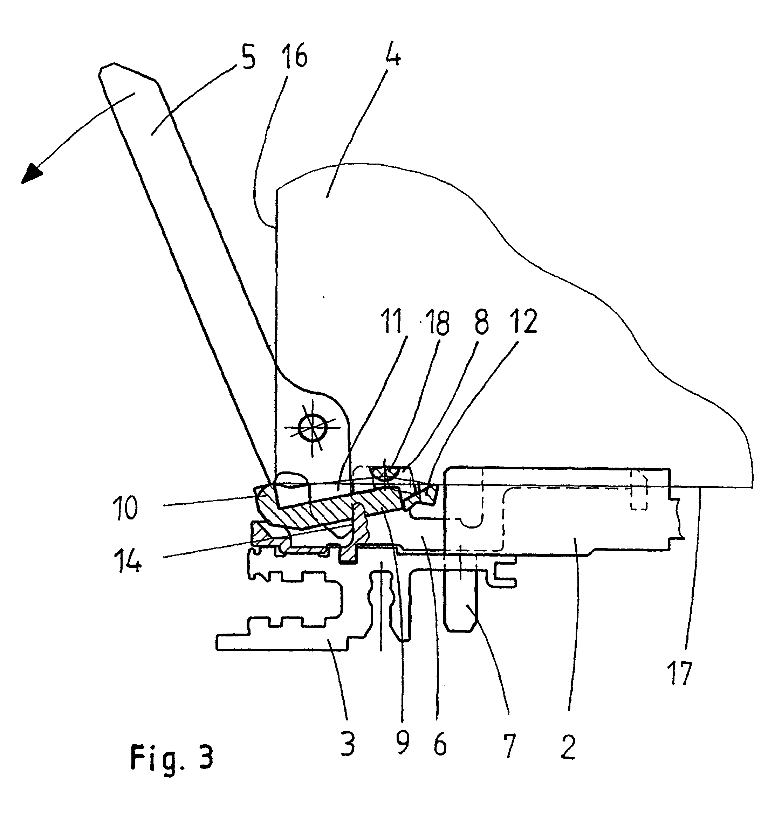

Figur 3 zeigt den Beginn des Aushebelns der Leiterkarte 4: Der Ein- und Aushebegriff 5 wurde bewegt, so daß er nun an der ersten Abdrückschulter 14 des Lagerelements 6 anliegt - das Ausziehen der Leiterkarte 4 kann beginnen. Bei dieser ersten Bewegung des Ein- und Aushebegriffs 5 wurde das Halteelement 10 der Wippe 9 so weit heruntergedrückt, daß ein Ausziehen der Leiterkarte 4 nun möglich ist. Der Federrahmen 11 der Kartensicherung 1 ist, da das Aktivierungselement 12 nach wie vor an der Längskante 17 der Leiterkarte 4 anliegt, jetzt maximal vorgespannt, so daß das Halteelement 10 sofort wieder vor die Vorderkante 16 der Leiterkarte 4 schnappt, wenn der Ein- und Aushebegriff wieder zurückbewegt wird.

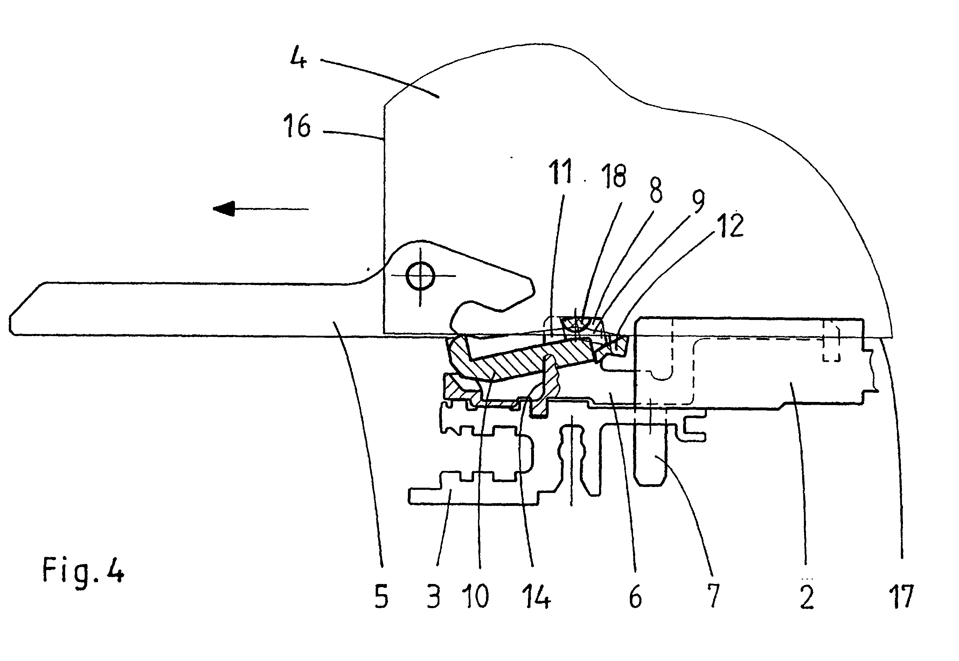

Figur 4 zeigt das Ausziehen der Leiterkarte 4 aus der Führungsschiene 2. Die Verformung des Federrrahmens 11 der Wippe 9 und die Stellungen des Halteelements 10 und des Aktivierungselements 12 haben sich gegenüber dem in Figur 3 gezeigten Zeitpunkt nicht verändert.

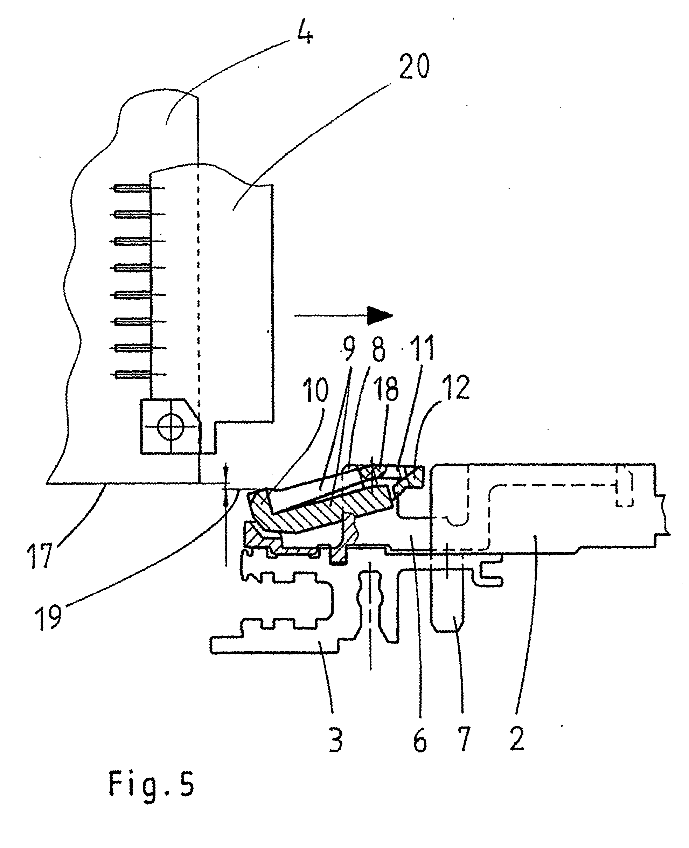

Sobald die Längskante 17 der Leiterkarte 4 das Aktivierungselement 12 passiert, weicht dieses nach oben aus, um die Verformung des Federrahmens 11 auszugleichen. Hierdurch entfällt die elastische Rückstellkraft auf das Halteelement 10, so daß dieses in seiner heruntergedrückten Lage stehen bleibt. Diese geöffnete Endposition der Kartensicherung 1 ist in Figur 5 dargestellt. Aus Figur 5 ist auch ersichtlich, daß die genannte Ruheposition so gewählt ist, daß das Halteelement 10 etwas unterhalb der Einschubebene 19 der Führungsschiene 2 liegt, so daß die Leiterkarte 4, von der hier schematisch auch die rückwärtigen Steckverbinder 20 dargestellt sind, ohne Behinderung durch die Kartensicherung 1 in die Führungsschiene 2 eingespurt werden kann.

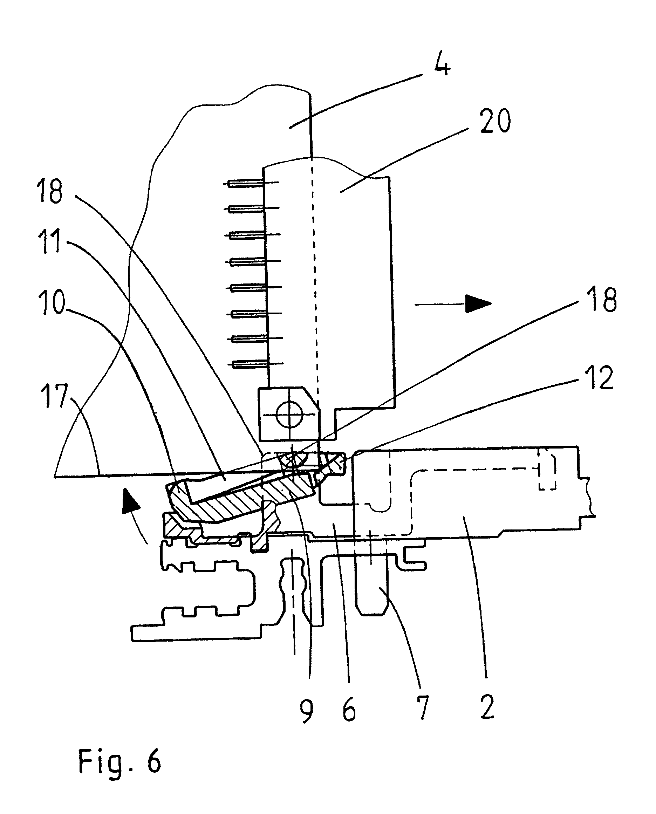

Figur 6 zeigt den Moment beim Einspuren einer Leiterkarte 4 in die Führungsschiene 2, in dem die Leiterkarte 4 auf das Aktivierungselement 12 aufläuft, dieses dabei nach unten drückt und über den Federrahmen 11 die Vorspannung auf das Halteelement 10 erzeugt, die dieses nach dem vollständigen Einschieben der Leiterkarte 4 vor die Vorderkante 16 derselben schnappen läßt.

### Zusammenstellung der Bezugszeichen

- 1: Kartensicherung
- 2: Führungsschiene
- 3: Modulschiene
- 4: Leiterkarte
- 5: Ein- und Aushebegriff
- 6: Lagerelement (von 1)
- 7: Schnapphaken (von 2)
- 8: Lagertragschale
- 9: Wippe
- 10: Halteelement
- 11: Federrahmen
- 12: Aktivierungselement
- 13: Auflaufschräge
- 14: Abdrückschulter (erste)
- 15: Abdrückschulter (zweite)
- 16: Vorderkante (von 4)
- 17: Längskante (von 4)
- 18: Lagerinnenteil
- 19: Einschubebene
- 20: Steckverbinder

## Patentansprüche

1. Kartensicherung zum Sichern einer Leiterkarte (4) in einer Führungsschiene (2) eines Baugruppenträgers, mit einem Halteelement (10), das bei in die Führungsschiene (2) eingeschobener Leiterkarte (4) vor der Vorderkante (16) derselben liegt und zum Herausziehen der Leiterkarte (4) gegen eine elastische Rückstellkraft wegschwenkbar ist, **dadurch gekennzeichnet, daß** die Kartensicherung (1) ein an das Halteelement (10) elastisch gekoppeltes Aktivierungselement (12) aufweist, welches bei eingeschobener Leiterkarte (4) an einer Längskante (17) derselben anliegt und eine elastische Rückstellkraft auf das Halteelement (10) ausübt, während es bei ausgezogener Leiterkarte (4) frei beweglich ist, wobei dann die elastische Rückstellkraft auf das Halteelement (10) entfällt.

2. Kartensicherung nach Anspruch 1, **dadurch gekennzeichnet, daß** das Halteelement (10) und das Aktivierungselement (12) einen gemeinsamen Drehpunkt besitzen.

3. Kartensicherung nach Anspruch 2, **dadurch gekennzeichnet, daß** das Halteelement (10) und das Aktivierungselement (12) eine elastisch verformbare Wippe (9) bilden.

4. Kartensicherung nach Anspruch 3, **dadurch gekennzeichnet, daß** ein an bzw. vor der Führungsschiene (2) befestigbares Lagerelement (6) vorgesehen ist, in welchem die Wippe (9) an ihrem Drehpunkt gelagert ist.

5. Kartensicherung nach einem der Ansprüche 1 bis 4, **dadurch gekennzeichnet, daß** ein Ein- und Aushebegriff (5) für die Leiterkarte (4) vorgesehen ist, mittels welchem das Halteelement (10) unter Ausnutzung der Hebelgesetze von der Vorderkante (16) der Leiterkarte (4) wegschwenkbar ist.

6. Kartensicherung nach den Ansprüchen 4 und 5, **dadurch gekennzeichnet, daß** das Lagerelement (6) eine erste Abdrückschulter (14) für den Ein- und Aushebegriff (5) aufweist.

7. Kartensicherung nach Anspruch 6, **dadurch gekennzeichnet, daß** das Lagerelement (6) eine zweite Abdrückschulter (15) für den Ein- und Aushebegriff (5) aufweist.

8. Kartensicherung nach einem der Ansprüche 1 bis 7, **dadurch gekennzeichnet, daß** das Halteelement (10) ein Sicherungsbügel ist.

9. Kartensicherung nach einem der Ansprüche 1 bis 8, **dadurch gekennzeichnet, daß** das Aktivierungselement (12) als Bügel ausgebildet ist.

10. Kartensicherung nach Anspruch 9, **dadurch gekennzeichnet, daß** das als Bügel ausgebildete Aktivierungselement (12) eine Auflaufschräge (13) für die Leiterkarte (4) aufweist.

11. Kartensicherung nach einem der Ansprüche 9 oder 10, **dadurch gekennzeichnet, daß** das als Bügel ausgebildete Aktivierungselement (12) Teil eines am Halteelement (10) angeformten Federrahmens (11) ist.

12. Kartensicherung nach einem der Ansprüche 1 bis 11, **dadurch gekennzeichnet, daß** das Halteelement (10) bei ausgezogener Leiterkarte (4) eine stabile Endlage unterhalb der Einschubebene (19) der Führungsschiene (2) einnimmt.

## Claims

1. A circuit card securing arrangement for securing a circuit card (4) in a guide rail (2) of a rack, with a retaining element (10) that lies in front of the front edge (16) of a circuit card (4) when inserted into the guide rail (2) and which is pivotable out of the way for the withdrawal of the circuit card (4) against a resilient biasing force, **characterised in that** the circuit card securing arrangement (1) has an activating element (12) that is resiliently coupled to the retaining element (10), lies against a longitudinal edge (17) of a circuit card (4) when the latter is pushed in and exerts a resilient biasing force on the retaining element (10) while being freely movable when the circuit card (4) has been pulled out, whereby then the resilient biasing force on the retaining element (10) ceases.

2. Circuit card securing arrangement according to claim 1, **characterised in that** the retaining element (10) and the activating element (12) have a common centre of rotation.

3. A circuit card securing arrangement according to claim 2, **characterised in that** the retaining element (10) and the activating element (12) form a resiliently deformable rocker (9).

4. A circuit card securing arrangement according to claim 3, **characterised in that** there is provided a bearing element (6) securable to or in front of the guide rail (2) and in which the rocker (9) is joumalled at its centre of rotation.

5. A circuit card securing arrangement according to one of claims 1 to 4, **characterised in that** an insertion and removal handle (5) is provided for the circuit card (4) and the retaining element (10) is pivotable away from the front edge (16) of the circuit card (4) by means of the handle by exploiting the lever principle.

6. A circuit card securing arrangement according to claims 4 and 5, **characterised in that** the bearing element (6) has a first release shoulder (14) for the insertion and removal handle (5).

7. A circuit card securing arrangement according to claim 6, **characterised in that** the bearing element (6) has a second release shoulder (15) for the insertion and removal handle (5).

8. A circuit card securing arrangement according to one of claims I to 7, **characterised in that** the retaining element (10) is a securing clip.

9. A circuit card securing arrangement according to one of claims 1 to 8, the activating element (12) is formed as a clip.

10. A circuit card securing arrangement according to claim 9, **characterised in that** the activating element (12) formed as a clip has a run-on ramp (13) for the circuit card (4).

11. A circuit card securing arrangement according to one of claims 9 or 10, **characterised in that** the activating element (12) formed as a clip is part of a spring frame (11) moulded to the retaining element (10).

12. A circuit card securing arrangement according to one of claims 1 to 11, **characterised in that** when the circuit card (4) is pulled out, the retaining element (10) takes up a stable end position beneath the slide-in plane (19) of the guide rail (2).

## Revendications

1. Dispositif de retenue de carte pour retenir une carte de circuit imprimé (4) dans un rail de guidage (2) d'une baie pour modules électroniques, comprenant un élément de retenue (10), qui se situe devant le bord avant (16) de la carte de circuit imprimé (4) en position d'insertion de cette dernière dans le rail de guidage (2) et qui peut pivoter à l'écart contre une force de rappel élastique pour le retrait de la carte (4), **caractérisé en ce que** le dispositif de retenue de carte (1) présente un élément d'activation (12), qui est couplé élastiquement à l'élément de retenue (10), s'applique sur un bord longitudinal (17) de la carte de circuit imprimé (4) en position d'insertion de cette dernière, et exerce une force de rappel élastique sur l'élément de retenue (10), tandis qu'il est librement mobile en position de retrait de la carte de circuit imprimé (4), la force de rappel élastique sur l'élément de retenue (10) étant alors supprimée.

2. Dispositif de retenue de carte suivant la revendication 1, **caractérisé en ce que** l'élément de retenue (10) et l'élément d'activation (12) présentent un centre de rotation commun.

3. Dispositif de retenue de carte suivant la revendication 2, **caractérisé en ce que** l'élément de retenue (10) et l'élément d'activation (12) forment une bascule (9) déformable élastiquement.

4. Dispositif de retenue de carte suivant la revendication 3, **caractérisé en ce qu'**il est prévu un élément d'appui (6), qui peut être fixé sur ou devant le rail de guidage (2) et dans lequel la bascule (9) est montée sur son centre de rotation.

5. Dispositif de retenue de carte suivant l'une des revendications 1 à 4, **caractérisé en ce qu'**il est prévu une manette d'insertion et de retrait (5) pour la carte de circuit imprimé (4), au moyen de laquelle l'élément de retenue (10) peut pivoter à l'écart du bord avant (16) de la carte de circuit imprimé (4) en utilisant les lois du levier.

6. Dispositif de retenue de carte suivant les revendications 4 et 5, **caractérisé en ce que** l'élément d'appui (6) présente un premier épaulement de poussée (14) pour la manette d'insertion et de retrait (5).

7. Dispositif de retenue de carte suivant la revendication 6, **caractérisé en ce que** l'élément d'appui (6) présente un second épaulement de poussée (15) pour la manette d'insertion et de retrait (5).

8. Dispositif de retenue de carte suivant l'une des revendications 1 à 7, **caractérisé en ce que** l'élément de retenue (10) est un étrier de blocage.

9. Dispositif de retenue de carte suivant l'une des revendications 1 à 8, **caractérisé en ce que** l'élément d'activation (12) est réalisé sous forme d'étrier.

10. Dispositif de retenue de carte suivant la revendication 9, **caractérisé en ce que** l'élément d'activation (12) réalisé sous forme d'étrier présente une rampe (13) pour la carte de circuit imprimé (4).

11. Dispositif de retenue de carte suivant l'une des revendications 9 et 10, **caractérisé en ce que** l'élément d'activation (12) réalisé sous forme d'étrier fait partie d'un cadre élastique (11) conformé sur l'élément de retenue (10).

12. Dispositif de retenue de carte suivant l'une des revendications 1 à 11, **caractérisé en ce que** l'élément de retenue (10), en position de retrait de la carte de circuit imprimé (4), occupe une position extrême stable au-dessous du plan d'insertion (19) du rail de guidage (2).
